# EUROPÄISCHE PATENTSCHRIFT

(11) **EP 0 656 742 B1**
(45) Veröffentlichungstag und Bekanntmachung des Hinweises auf die Patenterteilung: **18.09.1996**
(21) Anmeldenummer: 94117565.5
(22) Anmeldetag: 08.11.1994
(51) Int. Cl.: H05K 9/00

(54) **Abdichteinrichtung gegen hochfrequente Wellen oder Impulse**
High frequency waves or pulses shielding device
Dispositif de blindage contre les ondes et impulsions hautes fréquences

(30) Priorität: 01.12.1993 DE 9318353 U
(43) Veröffentlichungstag der Anmeldung: 07.06.1995
(73) Patentinhaber: M. Schall GmbH + Co. KG, D-52399 Merzenich (DE)
(72) Erfinder: Stuewe, Hans, D-50126 Bergheim-Kenten (DE)
(74) Vertreter: Paul, Dieter-Alfred, Dipl.-Ing.

(56) Entgegenhaltungen:
- EP-A- 0 320 592
- WO-A-88/04129
- GB-A- 2 183 920
- US-A- 3 962 550

## Beschreibung

Die Erfindung betrifft eine Abdichteinrichtung zum Abdichten von Spalten in Wandungen von Gehäusen gegen hochfrequente Wellen oder Impulse mit wenigstens einer sich längs des Spaltes erstreckenden Dichtungsanordnung, die eine Aufnahmenut auf einer ersten Spaltseite aufweist, in die ein elektrisch leitfähiger Dichtstreifen mit einem Fußabschnitt eingesetzt ist, der eine Hinterschneidung in der Aufnahmenut hinterfaßt, wobei der Dichtstreifen unter elastischer Vorspannung an der gegenüberliegenden zweiten Spaltseite anliegt.

Für nachrichtentechnische Sende- und Empfangsanlagen, Fernmeldeanlagen, Anlagen für militärische Zwecke, Datenverarbeitungsanlagen und auch für Steuer- und Meßgeräte werden Gehäuse benötigt, die gegen hochfrequente Einflüsse, z.B. elektromagnetische Interferenzen (EMI), elektromagnetische Pulse (EMP) oder nukleare elektromagnetische Pulse (NEMP), abgeschirmt sind. Dies stellt bei nicht unterbrochenen Wandungen des Gehäuses kein Problem dar. Im Bereich von Türen und öffenbaren Fenstern sind die Wandungen des Gehäuses durch Spalte zwangsläufig unterbrochen. Hier müssen besondere Maßnahmen getroffen werden, damit das Gehäuse möglichst vollständig hochfrequenzdicht ist. Hierzu sind Abdichteinrichtungen in vielfältigen Ausführungsformen bekannt.

Eine Abdichteinrichtung der eingangs genannten Art ist der DD-PS 221 90̸4 zu entnehmen. Bei dieser Abdichteinrichtung erstreckt sich zwischen zwei Wandelementen, von denen eines verschwenkbar ausgebildet ist, eine Dichtungsanordnung längs des dort vorhandenen Spaltes. Die Dichtungsanordnung hat einen im Querschnitt im wesentlichen trapezartigen Dichtstreifen aus einem Elastomerkern, wobei in den Dichtstreifen eine S-förmige Kontaktfeder eingebettet ist. Der Dichtstreifen sitzt mit einem Fußabschnitt in einer Aufnahmenut auf der einen Spaltseite und liegt unter elastischer Vorspannung an der gegenüberliegenden Spaltseite an. Dabei ist die Kontaktfeder so in den Elastomerkern eingebettet, daß er Kontakt zu beiden Spaltseiten hat, der Spalt also elektrisch leitend überbrückt wird.

Die Aufnahmenut weist beidseits Hinterschneidungen auf, hinter die der Fußabschnitt des Dichtstreifens faßt. Dies macht die Montage und auch die Demontage eines solchen Dichtstreifens schwierig und zeitaufwendig. Dabei besteht die Gefahr, daß der Dichtstreifen beschädigt wird. Außerdem kann es über die Länge des Dichtstreifens zu ungleichmäßigen Verspannungen kommen. Beides kann die Abdichtung gegen hochfrequente Einflüsse beeinträchtigen.

Der Erfindung liegt demnach die Aufgabe zugrunde, eine Abdichteinrichtung der eingangs genannten Art derart auszubilden, daß sie einfach einsetzbar und wieder herausnehmbar ist und daß dabei Beschädigungen und Verspannungen vermieden werden.

Die Aufgabe wird erfindungsgemäß dadurch gelöst, daß auf der der Hinterschneidung gegenüberliegenden Seite der Aufnahmenut wenigstens ein entfernbarer Sperrstift zur formschlüssigen Blockierung des Fußabschnittes in der Aufnahmenut vorgesehen ist, wobei der Dichtstreifen nach Entfernung des Sperrstiftes bzw. der Sperrstifte aus der Aufnahmenut herausnehmbar ist.

Bei der Abdichteinrichtung nach der Erfindung wird also nicht von dem Prinzip der Halterung des Dichtstreifens innerhalb einer Aufnahmenut abgewichen. Für die Halterung des Dichtstreifens ist jedoch ein besonderer Sperrstift vorgesehen, der entfernbar ist und nach seiner Entfernung ein problemloses Einsetzen bzw. Herausnehmen des Dichtstreifens aus der Aufnahmenut zuläßt. Nach dem Einsetzen des Dichtstreifens in die Aufnahmenut wird der Sperrstift in die Aufnahmenut eingeschoben und sorgt dann dafür, daß der Fußabschnitt des Dichtstreifens nicht mehr aus der Aufnahmenut herausfallen kann, also dort formschlüssig blockiert wird. Dies ermöglicht es, den Dichtstreifen so zu dimensionieren, daß er ohne Verspannung, sogar mit einer gewissen Lose, innerhalb der Aufnahmenut sitzt. Auf diese Weise werden hohe Dämpfungswerte und eine gleichbleibende Fertigungsqualität erreicht.

In Ausbildung der Erfindung ist vorgesehen, daß die Aufnahmenut eine der ersten gegenüberliegende zweite Hinterschneidung aufweist, die der Fußabschnitt hinterfaßt und in die der Sperrstift in einer solchen Position eingelassen ist, daß die Querbeweglichkeit des Dichtstreifens derart eingeschränkt ist, daß der Fußabschnitt hinter beide Hinterschneidungen faßt. In diesem Falle ist der Fußabschnitt des Dichtstreifens so dimensioniert, daß er nach Entfernen des Sperrstiftes in eine solche Position gebracht werden kann, daß er einfach und ohne Deformierung des Dichtstreifens aus der Aufnahmenut herausgenommen und auch wieder eingesetzt werden kann. Mit Einsetzen des Sperrstiftes wird der Dichtstreifen in eine solche Position gebracht, daß er hinter beide Hinterschneidungen faßt und auf diese Weise formschlüssig gehalten ist.

Dabei ist es vorzuziehen, daß der Sperrstift bzw. die Sperrstifte derart ausgebildet und angeordnet ist bzw. sind, daß der Fußabschnitt in Querrichtung unbeweglich gehalten ist. Der Sperrstift bzw. die Sperrstifte ist bzw. sind zweckmäßigerweise im Hinterschneidungsgrund eingesetzt, wobei dieser so ausgebildet sein kann, daß der Sperrstift bzw. die Sperrstifte dort unverlierbar gehalten sind.

Der Sperrstift bzw. die Sperrstifte ist bzw. sind zweckmäßigerweise als Rundstift ausgebildet.

In einer besonders bevorzugten Ausführungsform ist der Dichtstreifen im Querschnitt V-förmig ausgebildet, wobei ein erster V-Schenkel den Fußabschnitt bildet und ein zweiter V-Schenkel schräg aus der Aufnahmenut herausragt und federnd beweglich ist. Bei dieser Ausbildung des Dichststreifens kommt es zu einer Linienberührung auf der anderen Seite des Spaltes, wobei sich der Andruck sehr genau einstellen läßt. Außerdem eignet sich diese Formgebung des Dichtstreifens besonders gut für Spalte zwischen einem beweglichen und einem ortsfesten Wandelement, wie dies bei Türen und Fenstern der Fall ist.

Dabei sind die V-Schenkel vorzugsweise in Längsrichtung des Dichtstreifens durchgehend ausgebildet. Es besteht jedoch auch die Möglichkeit, in regelmäßigen Abständen Schlitze vorzusehen.

Der Bereich der Verbindung der V-Schenkel sollte hinter die erste Hinterschneidung fassen, so daß das freie Ende des ersten V-Schenkels, der den Fußabschnitt bildet, durch den Sperrstift bzw. die Sperrstifte beaufschlagt wird. Der Dichtstreifen kann in diesem Fall aus Federstahl oder auch aus einem metallgefüllten Polymer bestehen.

Nach der Erfindung ist ferner vorgeschlagen, daß eine Zusatzdichtung vorgesehen ist, welche eine Aufnahmenut auf einer Spaltseite und ein darin eingesetztes Dichtprofil aufweist, das aus einem elastischen Werkstoff besteht und unter elastischer Vorspannung auf der anderen Spaltseite anliegt. Dabei sollte das Dichtprofil eine Doppeldichtlippe für die Anlage an der anderen Spaltseite aufweisen und zur Außenseite des Gehäuses hin angebracht sein. Die Zusatzdichtung hat die Aufgabe, Umwelteinflüsse, wie beispielsweise Wasser und Staub, fernzuhalten, und zwar auch von der erfindungsgemäßen Dichtungsanordnung.

Die Erfindung sieht ferner vor, daß die Spaltseiten von Aufsteckprofilen gebildet sind, die stirnseitig auf Wandelemente des Gehäuses aufgesetzt sind und in die die Aufnahmenut(en) eingeformt ist bzw. sind. Solche Aufsteckprofile lassen eine Fertigung der Spaltseiten und deren besondere Ausbildung entsprechend der vorliegenden Erfindung unabhängig von der Gestaltung der Wandelemente selbst zu. Dabei können die Aufsteckprofile auch mit Scharnieren für die Aufhängung von Türen versehen sein. Insgesamt ergibt sich hierdurch eine einfache Fertigung und Montage. Außerdem können die Aufsteckprofile auch nachträglich ausgetauscht werden.

Die Aufsteckprofile sollten die Stirnseiten der Wandelemente U-förmig einfassen. Als Material kommt insbesondere Aluminium in Frage.

Vor allem bei Spalten, die Türen begrenzen, empfiehlt es sich, daß der Spalt einen sich in der Ebene der Wandungen des Gehäuses erstreckenden ersten Spaltabschnitt und einen sich dazu senkrecht erstreckenden zweiten Spaltabschnitt hat, der Spalt sich also in Querrichtung nicht gerade erstreckt. Dabei sollte schon in dem ersten Spaltabschnitt eine Dichtungsanordnung gemäß der vorliegenden Erfindung vorgesehen sein. Soweit eine Zusatzdichtung vorgesehen ist, sollte sie ebenfalls in dem ersten Spaltabschnitt angeordnet sein. Der zweite Spaltabschnitt kann zweckmäßigerweise sich zur Innenseite des Gehäuses hin erstrecken, so daß es nach außen hin zu einer Überdeckung dieses zweiten Spaltabschnittes kommt.

Die Dämpfungswirkung der erfindungsgemäßen Abdichteinrichtung gegen hochfrequente Einflüsse kann noch dadurch erhöht werden, daß in Querrichtung des Spaltes hintereinander wenigstens zwei Dichtungsanordnungen vorgesehen sind. Dabei sollten, wenn der Spalt in zwei senkrecht zueinander stehende Spaltabschnitte aufgeteilt ist, mindestens eine Dichtungsanordnung auch in dem zweiten Spaltabschnitt angeordnet sein. Zweckmäßigerweise ist die zweite Dichtungsanordnung derart am Übergang vom ersten zum zweiten Spaltabschnitt angeordnet, daß der Dichtstreifen an der sich dort befindenden Übergangskante anliegt.

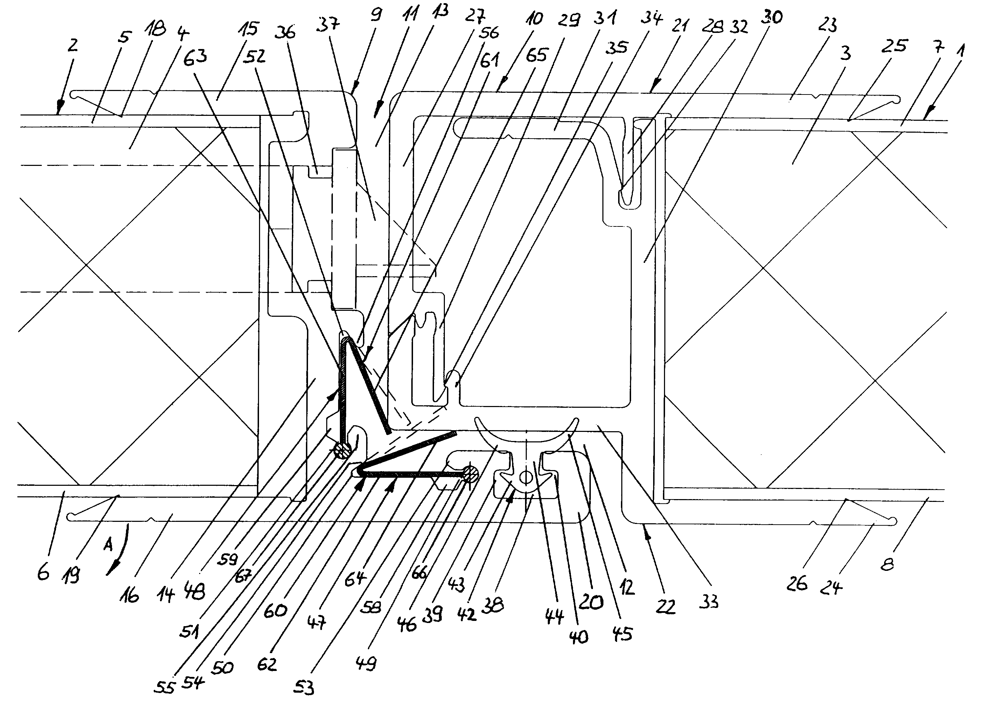

In der Zeichnung ist die Erfindung an Hand eines Ausführungsbeispiels näher veranschaulicht. Sie zeigt in einem horizontalen Schnitt einen Ausschnitt, der zu einer Wandung eines Gehäuses gehört. Es ist ein erstes, gehäusefestes Wandelement (1) vorgesehen, an das stirnseitig ein zweites Wandelement in Form einer Tür (2) angrenzt, die in Richtung des Pfeils (A) öffenbar ist.

Wandelement (1) und Tür (2) haben einen Sandwichkern (3, 4), die jeweils an beiden Flachseiten mit Aluminiumblechen (5, 6, 7, 8) beplankt sind. Auf die Stirnseiten von Wandelement (1) und Tür (2) sind Aufsteckprofile (9, 10̸) aufgesetzt, zwischen denen sich ein Spalt (11) mit einem ersten, in der Ebene von Wandelement (1) und Tür (2) verlaufenden Spaltabschnitt (12) und einem darin anschließenden, quer zur Ebene von Wandelement (1) und Tür (2) sich erstreckenden zweiten Spaltabschnitt (13) verläuft. Beide Aufsteckprofile (9, 10̸) bestehen aus Aluminium.

Das türseitige Aufsteckprofil (9) weist einen den zweiten Spaltabschnitt (13) begrenzenden Querprofilabschnitt (14) auf, an den sich beidseits Einfaßstege (15, 16) anschließen, die mit der Tür (2) überlappen. Die Einfaßstege (15, 16) haben innenseitig vorspringende Kanten (18, 19), die auf Grund der Vorspannung, mit der die Einfaßstege (15, 16) an den Aluminiumblechen (5, 6) anliegen, ein wenig in das Material der Aluminiumbleche (5, 6) eingegraben sind und auf diese Weise für eine gut leitende und deshalb hochfrequenzdichte Abdichtung in diesem Bereich sorgen. Auf der Außenseite der Tür (2) hat das Aufsteckprofil (9) einen den ersten Spaltabschnitt (12) begrenzenden Überlappungssteg (20̸), der sich entgegen der Richtung des Einfaßsteges (16) in Richtung auf das Wandelement (1) erstreckt.

Das wandelementseitige Aufsteckprofil (10̸) ist zweiteilig ausgebildet. Es hat ein erstes, gehäuseinnenseitig angeordnetes Aufsteckprofilteil (21) und ein mit diesem verhaktes, im wesentlichen gehäuseaußenseitig angeordnetes zweites Aufsteckprofilteil (22). Beide Aufsteckprofilteile (21, 22) haben je einen Einfaßsteg (23, 24), über die sie mit dem Wandelement (1) überlappen. Innenseitig weisen auch diese Einfaßstege (23, 24) vorspringende Kanten (25, 26) auf, die ein wenig in die Außenseiten der Aluminiumbleche (7, 8) eingegraben sind.

Bei dem ersten Aufsteckprofilteil (21) setzt sich der Einfaßsteg (23) zur Tür (2) hin fort und biegt dann in einen Querschenkel (27) um, der sich im wesentlichen parallel zum Querprofilabschnitt (14) des türseitigen Aufsteckprofils (9) erstreckt und auf diese Weise den größten Teil des zweiten Spaltabschnittes (13) begrenzt. Das erste Aufsteckprofilteil (21) hat im Bereich der Stirnseite des Wandelements (1) einen parallel dazu sich erstreckenden, ersten Hakensteg (28) und einen von der freien Kante des Querschenkels (27) nach innen abgehenden, zweiten Hakensteg (29).

Das zweite Aufsteckprofilteil (22) weist einen sich parallel zur Stirnseite des Wandelements (1) erstreckenden Querprofilabschnitt (30̸) auf, von dem ein Führungsschenkel (31) abgeht, der sich zunächst parallel zur Stirnseite des Wandelements (1) und dann parallel zu der Verlängerung des Einfaßsteges (23) erstreckt. Dabei bilden Querprofilabschnitt (30̸) und Führungsschenkel (31) eine Nut, in die der erste Hakensteg (28) einfaßt. Dieser sowie der Führungsschenkel (31) haben sich gegenseitig hinterfassende Kanten (32).

Senkrecht zum Querprofilabschnitt (30̸) geht ein L-Schenkel ab, dessen erster Teil den ersten Spaltabschnitt (12) und dessen zweiter Teil zusammen mit dem Querschenkel (27) den zweiten Spaltabschnitt (13) begrenzen. Querschenkel (27) und L-Schenkel (33) stoßen sich schräg überlappend aufeinander. Von dem ersten Teil des L-Schenkels (33) ragt ein dritter Hakensteg (34) nach innen, wobei sich dritter Hakensteg (34) und zweiter Hakensteg (29) an einer Kante (35) gegenseitig hinterfassen. Auf diese Weise entsteht ein von beiden Aufsteckprofilteilen (21, 22) gebildetes Kastenprofil, das von dem Überlappungssteg (20̸) überlappt wird.

Der Querprofilabschnitt (14) des türseitigen Aufsteckprofils (9) weist eine Nut (36) auf, in der ein lediglich strichpunktiert dargestellter Schloßriegel (37) geführt ist. Dessen dreiecksförmiges Ende faßt in eine hier nicht näher dargestellte öffnung in dem Querschenkel (27) des ersten Aufsteckprofilteils (21) ein. Der Schloßriegel (37) läßt sich in die Tür (2) einziehen, so daß die Tür (2) für das öffnen in Richtung des Pfeils (A) freigegeben wird.

Der Überlappungssteg (20̸) hat eine erste Aufnahmenut (38), welche mit zwei Hinterschneidungen (39, 40̸) versehen ist. In die erste Aufnahmenut (38) ist ein Dichtprofil (42) aus einem elastomeren Material eingesetzt. Hierzu hat das Dichtprofil (42) einen sich hutförmig verbreiternden, die Hinterschneidungen (39, 40̸) hinterfassenden Fußabschnitt (43), von dem ein Profilschenkel (44) nach außen in Richtung auf den ersten Spaltabschnitt (12) ausgeht. Von dem Profilschenkel (44) stehen zwei Dichtlippen (45, 46) ab, die unverformt dargestellt sind. Tatsächlich liegen sie mit ihren freien Kanten unter Vorspannung und nach außen verformt an der Außenseite des L-Schenkels (33) des zweiten Aufsteckprofilteils (22) an. Das Dichtprofil (42) dient als Umweltdichtung, soll also Spritzwasser und Staub abhalten.

In den Überlappungssteg (20̸) und in den Querprofilabschnitt (14) sind eine zweite und eine dritte Aufnahmenut (47, 48) eingeformt. Sie sind identisch ausgebildet und haben jeweils Hinterschneidungen (49, 50̸, 51, 52) bildende, die Öffnung der Aufnahmenuten (47, 48) begrenzende Randvorsprünge (53, 54, 55, 56). Im Bereich der jeweils rechtsseitigen Randvorsprünge (53, 55) weisen die Aufnahmenuten (47, 48) im Querschnitt trapezförmige Vertiefungen (58, 59) auf. Die dortigen Hinterschneidungen (49, 51) laufen in einen etwas mehr als halbkreisförmigen Querschnitt aus.

In die Aufnahmenuten (47, 48) sind Abdichtprofile (60̸, 61) eingesetzt. Die Abdichtprofile (60̸, 61) sind im Querschnitt V-förmig ausgebildet, haben also jeweils einen ersten V-Schenkel (62, 63) und jeweils einen damit verbundenen zweiten V-Schenkel (64, 65). Die ersten V-Schenkel (62, 63) sitzen innerhalb der Aufnahmenuten (47) bzw. (48) und liegen dort flächig am Nutgrund an. Sie verlaufen jeweils parallel zum ersten Spaltabschnitt (12) bzw. zweiten Spaltabschnitt (13). Die ersten V-Schenkel (62, 63) ragen dabei in die Hinterschneidungen (49, 50̸, 51, 52) hinein und werden von den dortigen Randvorsprüngen (53, 54, 55, 56) formschlüssig innerhalb der Aufnahmenut (47, 48) gehalten und bilden auf diese Weise die Fußabschnitte der Abdichtprofile (60̸, 61).

Die zweiten V-Schenkel (64, 65) ragen aus den jeweils linksseitigen Hinterschneidungen (50̸, 52) schräg nach außen vor, wobei der zweite V-Schenkel (64) des Abdichtprofils (60̸) den ersten Spaltabschnitt (12) und der zweite V-Schenkel (65) des Abdichtprofils (61) den zweiten Spaltabschnitt (13) überbrücken. Beide zweite V-Schenkel (64, 65) liegen unter Vorspannung an den L-Schenkel (33) des zweiten Aufsteckprofilteils (22) an, und zwar der zweite V-Schenkel (64) des Abdichtprofils (60̸) im Bereich des ersten Spaltabschnittes (12) und der zweite V-Schenkel (65) des Abdichtprofils (61) am Übergang vom ersten Spaltabschnitt (12) zum zweiten Spaltabschnitt (13) und dort an der Kante des L-Schenkels (33).

In die etwa halbkreisformig ausgebildeten Enden der Hinterschneidungen (49, 51) sind passende Sperrstifte (66, 67) eingesetzt, die sich über die gesamte Höhe der Tür (2) erstrecken sowie oben- und untenseitig durch Schrauben in ihrer Lage gesichert sind. An den Sperrstiften (66, 67) liegen die freien Kanten der ersten V-Schenkel (62) bzw. (63) an. Auf diese Weise werden die Abdichtprofile (60̸, 61) in Querrichtung unbeweglich gehalten, so daß sie nicht aus den Aufnahmenuten (47, 48) herausbewegbar sind.

Die Abdichtprofile (60̸, 61) bestehen aus Federstahl. Beim öffnen der Tür (2) verschwenken deren zweite V-Schenkel (64, 65) in die gestrichelt dargestellte Stellung, federn also auf. Beim Schließen der Tür (2) werden sie dann wieder in die gezeigte Stellung nach Anlage an demn L-Schenkel (33) verschwenkt.

Die Abdichtprofile (60̸, 61) lassen sich auf einfache Weise aus den Aufnahmenuten (47) bzw. (48) entfernen oder auch wieder einsetzen. Hierzu werden die Sperrstifte (66, 67) bei geöffneter Tür (2) und nach Entfernung der oben- und untenseitigen Sicherungsschrauben (hier nicht dargestellt) nach oben herausgezogen. Danach können die Abdichtprofile (60̸, 61) tiefer in die jeweils rechtsseitigen Hinterschneidungen (49, 51) querbewegt werden. Die Abdichtprofile (60̸, 61) kommen dann in dem Bereich der linksseitigen Hinterschneidungen (50̸, 52) frei und können dort herausgeschwenkt werden. Dabei geben die Vertiefungen (58, 59) genügend Freiheit, um die freien Enden der ersten V-Schenkel (62, 63) aus den dortigen Hinterschneidungen (49, 51) herausbewegen zu können. Das Einsetzen von neuen Abdichtprofilen (60̸, 61) geschieht dann in umgekehrter Weise.

## Patentansprüche

1. Abdichteinrichtung zum Abdichten von Spalten (11) in Wandungen von Gehäusen gegen hochfrequente Wellen oder Impulse mit wenigstens einer sich längs des Spaltes (11) erstreckenden Dichtungsanordnung (60̸, 61), die eine Aufnahmenut (47, 48) auf einer ersten Spaltseite aufweist, in die ein elektrisch leitfähiger Dichtstreifen (60̸, 61) mit einem Fußabschnitt (62, 63) eingesetzt ist, der eine Hinterschneidung (50̸, 52) in der Aufnahmenut (47, 48) hinterfaßt, wobei der Dichtstreifen (60̸, 61) unter elastischer Vorspannung an der gegenüberliegenden Spaltseite anliegt,
dadurch gekennzeichnet, daß auf der der Hinterschneidung (50̸, 52) gegenüberliegenden Seite der Aufnahmenut (47, 48) wenigstens ein entfernbarer Sperrstift (66, 67) zur formschlüssigen Blockierung des Fußabschnittes (62, 63) in der Aufnahmenut (47, 48) vorgesehen ist, wobei der Dichtstreifen (60̸, 61) nach Entfernung des Sperrstiftes (66, 67) bzw. der Sperrstifte aus der Aufnahmenut (47, 48) herausnehmbar ist.

2. Abdichteinrichtung nach Anspruch 1,
dadurch gekennzeichnet, daß die Aufnahmenut (47, 48) eine der ersten gegenüberliegende zweite Hinterschneidung (49, 51) aufweist, die der Fußabschnitt (62, 63) hinterfaßt und in die der Sperrstift (66, 67) in einer Position eingelassen ist, daß die Querbeweglichkeit des Dichtstreifens (60̸, 61) derart eingeschränkt ist, daß der Fußabschnitt (62, 63) hinter beide Hinterschneidungen (49, 50, 51, 52) faßt.

3. Abdichteinrichtung nach Anspruch 2,
dadurch gekennzeichnet, daß der Sperrstift (66, 67) bzw. die Sperrstifte derart ausgebildet und angeordnet ist bzw. sind, daß der Fußabschnitt (62, 63) in Querrichtung unbeweglich gehalten ist.

4. Abdichteinrichtung nach Anspruch 2 oder 3,
dadurch gekennzeichnet, daß der Sperrstift (66, 67) bzw. die Sperrstifte im Hinterschneidungsgrund eingesetzt ist bzw. sind.

5. Abdichteinrichtung nach einem der Ansprüche 1 bis 4,
dadurch gekennzeichnet, daß der Sperrstift (66, 67) bzw. die Sperrstifte jeweils als Rundstift ausgebildet ist bzw. sind.

6. Abdichteinrichtung nach einem der Ansprüche 1 bis 5,
dadurch gekennzeichnet, daß der Dichtstreifen (60, 61) im Querschnitt V-förmig ausgebildet ist, wobei ein erster V-Schenkel (62, 63) den Fußabschnitt bildet und ein zweiter V-Schenkel (64, 65) schräg aus der Aufnahmenut (47, 48) herausragt und federnd beweglich ist.

7. Abdichteinrichtung nach Anspruch 6,
dadurch gekennzeichnet, daß der Bereich der Verbindung der V-Schenkel (62, 63, 64, 65) hinter die erste Hinterschneidung (50, 52) faßt.

8. Abdichteinrichtung nach Anspruch 6 oder 7,
dadurch gekennzeichnet, daß die freie Kante des zweiten V-Schenkels (64, 65) mit Linienberührung an der zweiten Spaltseite anliegt.

9. Abdichteinrichtung nach einem der Ansprüche 6 bis 8,
dadurch gekennzeichnet, daß der Dichtstreifen (60, 61) aus Federstahl besteht.

10. Abdichteinrichtung nach einem der Ansprüche 1 bis 9,
dadurch gekennzeichnet, daß eine Zusatzdichtung vorgesehen ist, welche eine Aufnahmenut (38) auf einer Spaltseite und ein darin eingesetztes Dichtprofil (42) aufweist, das aus einem elastischen Werkstoff besteht und unter elastischer Vorspannung an der anderen Spaltseite anliegt.

11. Abdichteinrichtung nach Anspruch 10,
dadurch gekennzeichnet, daß das Dichtprofil (42) eine Doppeldichtlippe (45, 46) für die Anlage an der anderen Spaltseite aufweist.

12. Abdichteinrichtung nach Anspruch 10 oder 11,
dadurch gekennzeichnet, daß die Zusatzdichtung (38, 42) zur Außenseite des Gehäuses hin angebracht ist.

13. Abdichteinrichtung nach einem der Ansprüche 1 bis 12,
dadurch gekennzeichnet, daß die Spaltseiten von Aufsteckprofilen (9, 10) gebildet sind, die stirnseitig auf Wandelemente (1, 2) des Gehäuses aufgesetzt sind und in die die Aufnahmenut(en) (38, 47, 48) eingeformt ist bzw. sind.

14. Abdichteinrichtung nach Anspruch 13,
dadurch gekennzeichnet, daß die Aufsteckprofile (9, 10) die Stirnseiten der Wandelemente (1, 2) U-förmig umfassen.

15. Abdichteinrichtung nach einem der Ansprüche 1 bis 14,
dadurch gekennzeichnet, daß der Spalt (11) einen sich in der Ebene der Wandelemente (1, 2) des Gehäuses erstreckenden, ersten Spaltabschnitt (12) und einen sich dazu senkrecht erstreckenden zweiten Spaltabschnitt (13) hat.

16. Abdichteinrichtung nach Anspruch 15,
dadurch gekennzeichnet, daß in dem ersten Spaltabschnitt (12) eine Dichtungsanordnung (47, 60) vorgesehen ist.

17. Abdichteinrichtung nach einem der Ansprüche 10 bis 12 sowie dem Anspruch 16,
dadurch gekennzeichnet, daß in dem ersten Spaltabschnitt (12) die Zusatzdichtung (38, 42) angeordnet ist.

18. Abdichteinrichtung nach Anspruch 16 oder 17,
dadurch gekennzeichnet, daß sich der zweite Spaltabschnitt (13) zur Innenseite des Gehäuses hin erstreckt.

19. Abdichteinrichtung nach einem der Ansprüche 1 bis 18,
dadurch gekennzeichnet, daß in Querrichtung des Spaltes (11) hintereinander wenigstens zwei Dichtungsanordnungen (47, 48, 60, 61) vorgesehen sind.

20. Abdichteinrichtung nach einem der Ansprüche 16 bis 18 sowie Anspruch 19,
dadurch gekennzeichnet, daß mindestens eine Dichtungsanordnung (48, 61) in dem zweiten Spaltabschnitt (13) angeordnet ist.

## Claims

1. Sealing device for sealing gaps (11) in walls of housings against radio-frequency waves or pulses, having at least one sealing arrangement (60, 61) which extends along the gap (11) and has a receiving groove (47, 48) on a first gap side, into which there is inserted an electrically conductive sealing strip (60, 61) having a foot section (62, 63) which grips behind an undercut (50, 52) in the receiving groove (47, 48), the sealing strip (60, 61) bearing against the opposite gap side under elastic prestressing, characterized in that at least one removable blocking pin (66, 67) is provided on that side of the receiving groove (47, 48) which is opposite the undercut (50, 52) for the purpose of positively blocking the foot section (62, 63) in the receiving groove (47, 48), it being possible to extract the sealing strip (60, 61) from the receiving groove (47, 48) after removal of the blocking pin (66, 67) or of the blocking pins.

2. Sealing device according to Claim 1, characterized in that the receiving groove (47, 48) has a second undercut (49, 51) which is opposite the first and grips behind the foot section (62, 63) and into which the blocking pin (66, 67) is inserted a position such that the transverse movability of the sealing strip (60, 61) is limited in such a way that the foot section (62, 63) grips behind the two undercuts (49, 50, 51, 52).

3. Sealing device according to Claim 2, characterized in that the blocking pin (66, 67) or the blocking pins is or are designed and arranged in such a way that the foot section (62, 63) is held immovably in the transverse direction.

4. Sealing device according to Claim 2 or 3, characterized in that the blocking pin (66, 67) or the blocking pins is or are inserted in the base of the undercut.

5. Sealing device according to one of Claims 1 to 4, characterized in that the blocking pin (66, 67) or the blocking pins is or are respectively designed as a round pin or as round pins.

6. Sealing device according to one of Claims 1 to 5, characterized in that the sealing strip (60, 61) is designed with a V-shaped cross-section, a first V limb (62, 63) forming the foot section and a second V limb (64, 65) projecting obliquely from the receiving groove (47, 48) and being resiliently movable.

7. Sealing device according to Claim 6, characterized in that the region of the connection of the V limbs (62, 63, 64, 65) grips behind the first undercut (50, 52).

8. Sealing device according to Claim 6 or 7, characterized in that the free edge of the second V limb (64, 65) bears against the second gap side with linear contact.

9. Sealing device according to one of Claims 6 to 8, characterized in that the sealing strip (60, 61) consists of spring steel.

10. Sealing device according to one of Claims 1 to 9, characterized in that an additional seal is provided which has a receiving groove (38) on one gap side and a sealing profile (42) which is inserted therein, the sealing profile consisting of an elastic material and bearing against the other gap side under elastic prestressing.

11. Sealing device according to Claim 10, characterized in that the sealing profile (42) has a double sealing lip (45, 46) for bearing against the other gap side.

12. Sealing device according to Claim 10 or 11, characterized in that the additional seal (38, 42) is attached towards the outside of the housing.

13. Sealing device according to one of Claims 1 to 12, characterized in that the gap sides are formed by plug-on profiles (9, 10) which are mounted endwise on wall elements (1, 2) of the housing and in which the receiving groove(s) (38, 47, 48) is or are shaped.

14. Sealing device according to Claim 13, characterized in that the plug-on profiles (9, 10) grip the ends of the wall elements (1, 2) in a U-shaped fashion.

15. Sealing device according to one of Claims 1 to 14, characterized in that the gap (11) has a first gap section (12) extending in the plane of the wall elements (1, 2) of the housing, and a second gap section (13) extending at right angles thereto.

16. Sealing device according to Claim 15, characterized in that a sealing arrangement (47, 60) is provided in the first gap section (12).

17. Sealing device according to one of Claims 10 to 12 and to Claim 16, characterized in that the additional seal (38, 42) is arranged in the first gap section (12).

18. Sealing device according to Claim 16 or 17, characterized in that the second gap section (13) extends towards the inside of the housing.

19. Sealing device according to one of Claims 1 to 18, characterized in that at least two sealing arrangements (47, 48, 60, 61) are provided one behind another in the transverse direction of the gap (11).

20. Sealing device according to one of Claims 16 to 18 and to Claim 19, characterized in that at least one sealing arrangement (48, 61) is arranged in the second gap section (13).

## Revendications

1. Dispositif de blindage pour rendre étanches vis-à-vis d'ondes ou d'impulsions de haute fréquence des interstices (11) qui sont présents dans des parois d'enceintes, comprenant au moins un agencement de blindage (60, 61) qui s'étend le long de l'interstice (11) et qui présente, sur un premier côté de l'interstice, une rainure formant logement (47, 48) dans laquelle est insérée une bande de blindage (60, 61) conductrice de l'électricité et pourvue d'une semelle (62, 63) qui vient en prise par l'arrière avec une contre-dépouille (50, 52) ménagée dans la rainure formant logement (47, 48), cependant que la bande de blindage (60, 61) porte sur le côté opposé de l'interstice avec une compression élastique initiale, caractérisé par le fait qu'il est prévu, sur le côté de la rainure formant logement (47, 48) qui est opposé à la contre-dépouille (50, 52), au moins une tige de blocage amovible (66, 67) destinée au blocage par conjugaison des formes de la semelle (62, 63) dans la rainure formant logement (47, 48), la bande de blindage (60, 61) pouvant être retirée de la rainure formant logement (47, 48) après que l'on a enlevé la tige de blocage (66, 67) ou les tiges de blocage, respectivement.

2. Dispositif de blindage selon la revendication 1, caractérisé par le fait que la rainure formant logement (47, 48) présente une deuxième contre-dépouille (49, 51) qui est opposée à la première, avec laquelle la semelle (62, 63) vient en prise par l'arrière et dans laquelle la tige de blocage (66, 67) est introduite dans une position telle que la mobilité transversale de la bande de blindage (60, 61) soit limitée de façon à ce que la semelle (62, 63) vienne en prise par l'arrière avec les deux contre-dépouilles (49, 50, 51, 52).

3. Dispositif de blindage selon la revendication 2, caractérisé par le fait que la tige de blocage (66, 67) ou les tiges de blocage, respectivement, est conformée ou sont conformées, respectivement, d'une manière telle que la semelle (62, 63) soit maintenue sans pouvoir se déplacer dans la direction transversale.

4. Dispositif de blindage selon la revendication 2 ou 3, caractérisé par le fait que la tige de blocage (66, 67) ou les tiges de blocage, respectivement, est introduite ou sont introduites, respectivement, dans le fond de la contre-dépouille.

5. Dispositif de blindage selon l'une des revendications 1 à 4, caractérisé par le fait que la tige de blocage (66, 67) ou les tiges de blocage, respectivement, est réalisée ou sont réalisées chacune, respectivement, sous la forme d'une tige à section circulaire.

6. Dispositif de blindage selon l'une des revendications 1 à 5, caractérisé par le fait que la bande de blindage (60, 61) présente la forme d'un V en section transversale, une première aile (62, 63) du V constituant la semelle et une deuxième aile (64, 65) du V faisant saillie obliquement hors de la rainure formant logement (47, 48) en étant mobile élastiquement.

7. Dispositif de blindage selon la revendication 6, caractérisé par le fait que la région de la liaison entre les ailes (62, 63, 64, 65) du V est en prise par l'arrière avec la première contre-dépouille (50, 52).

8. Dispositif de blindage selon la revendication 6 ou 7, caractérisé par le fait que le bord libre de la deuxième aile (64, 65) du V porte sur le deuxième côté de l'interstice selon un contact linéaire.

9. Dispositif de blindage selon l'une des revendications 6 à 8, caractérisé par le fait que la bande de blindage (60, 61) est constituée par de l'acier à ressort.

10. Dispositif de blindage selon l'une des revendications 1 à 9, caractérisé par le fait qu'il est prévu une étanchéité supplémentaire qui comporte une rainure formant logement (38) sur un côté de l'interstice et un profilé d'étanchéité (42) qui est inséré dans celle-ci, qui est constitué par une matière élastique et qui porte sur l'autre côté de l'interstice avec une compression élastique préalable.

11. Dispositif de blindage selon la revendication 10, caractérisé par le fait que le profilé d'étanchéité (42) comporte une lèvre d'étanchéité double (45, 46) qui est destinée à son appui sur l'autre côté de l'interstice.

12. Dispositif de blindage selon la revendication 10 ou 11, caractérisé par le fait que l'étanchéité supplémentaire (38, 42) est montée en étant dirigée vers le côté extérieur de l'enceinte.

13. Dispositif de blindage selon l'une des revendications 1 à 12, caractérisé par le fait que les côtés de l'interstice sont constitués par des profilés à enfoncer (9, 10) qui sont posés frontalement sur des éléments de paroi (1, 2) de l'enceinte et dans lesquels est formée ou sont formées, respectivement, la ou les rainures formant logement(s) (38, 47, 48).

14. Dispositif de blindage selon la revendication 13, caractérisé par le fait que les profilés à enfoncer (9, 10) enserrent en forme de U les côtés frontaux des éléments de paroi (1, 2).

15. Dispositif de blindage selon l'une des revendications 1 à 14, caractérisé par le fait que l'interstice (11) comporte une première partie d'interstice (12) qui s'étend dans le plan des éléments de paroi (1, 2) de l'enceinte et une deuxième partie d'interstice (13) qui s'étend perpendiculairement à la première.

16. Dispositif de blindage selon la revendication 15, caractérisé par le fait qu'un dispositif d'étanchéité (47, 60) est prévu dans la première partie (12) de l'interstice.

17. Dispositif de blindage selon l'une des revendications 10 à 12, ainsi que selon la revendication 16, caractérisé par le fait que l'étanchéité supplémentaire (38, 42) est disposée dans la première partie (12) de l'interstice.

18. Dispositif de blindage selon la revendication 16 ou 17, caractérisé par le fait que la deuxième partie (13) de l'interstice s'étend vers le côté intérieur de l'enceinte.

19. Dispositif de blindage selon l'une des revendications 1 à 18, caractérisé par le fait qu'il est prévu au moins deux dispositifs d'étanchéité (47, 48, 60, 61) qui sont disposés l'un derrière l'autre dans la direction transversale de l'interstice (11).

20. Dispositif de blindage selon l'une des revendications 16 à 18, ainsi que selon la revendication 19, caractérisé par le fait qu'au moins un dispositif d'étanchéité (48, 61) est disposé dans la deuxième partie (13) de l'interstice.
